# EUROPEAN PATENT SPECIFICATION

(11) **EP 1 783 914 B1**
(45) Date of publication and mention of the grant of the patent: **05.08.2009**
(21) Application number: 06301027.6
(22) Date of filing: 09.10.2006
(51) Int. Cl.: H03L 7/14, H03L 7/22

(54) **Switchable PLL circuit including two loops**
Schaltbarer PLL Schaltkreis mit zwei Loops
Circuit PLL commutable avec deux boucles de verrouillage de phase

(30) Priority: 08.11.2005 EP 05110472
(43) Date of publication of application: 09.05.2007
(73) Proprietor: Thomson Licensing, 92100 Boulogne (FR)
(72) Inventor: Schäfer, Ralf-Detlef, 29221 Celle (DE); Drexler, Michael, 30989 Gehrden (DE)
(74) Representative: Lindemann, Robert

(56) References cited:
- EP-A- 0 509 706
- US-A- 5 530 389
- US-A1- 2005 083 099
- US-B1- 6 204 732

## Description

The invention relates to an electronic circuit including two PLL circuits which can be switched between different configurations. In particular, the invention relates to PLL circuits in which controlled oscillators have to be locked with respect to frequency and phase to an input clock.

Electronic circuits which are supplied an input signal at a certain clock frequency often need to process the received input signal in further processing stages. Therefore, fixed relationships between the clocks used inside the further processing stages and the input signal are required. A further requirement is that the clocks have a very low jitter, i.e., the very low fluctuations in frequency or phase. To this end the input signal is often supplied to a phase lock loop circuit, or PLL circuit, which synchronises a controllable oscillator with the input signal.

EP 0 509 706 A2 discloses a circuit in which clock signals synthesized by a first PLL circuit are monitored by a second PLL circuit. For monitoring purposes, the second PLL circuit receives an output signal from the first PLL.

US 6,204,732 B1 discloses a clock distribution apparatus having two essentially identical circuits clock distribution units (CDUs) using PLLs. The output signals of the CDUs can be switched over. In order to make the switchover transparent to connected circuitry, the two CDUs are kept coherent in frequency and phase.

One particular type of PLL circuits uses a temperature compensated voltage controlled oscillator (TCXO). TCXOs exhibit excellent temperature and jitter behaviour. Oscillators of this type, however, have a very small frequency pulling range, i.e. the output frequency of this type of oscillator only be changed within a small range around the nominal frequency. As a result, PLL circuits using TCXO oscillators have a very small locking range, i.e. the difference between the input signal frequency and the nominal frequency of the oscillator must not be very large. PLL circuits that have a larger locking range can be built using voltage controlled oscillators (VCXO), which have a larger pulling range. VCXOs, however, are less stable in frequency and phase compared to TCXOs and thus the output signal of a PLL circuit using VCXOs may have a higher amount of clock jitter compared to a PLL circuit using a TCXO.

US 5,530,389 discloses a first and a second PLL circuit in a series arrangement. A switch is provided such that either the series arrangement or only the second PLL is used.

US 2005/0083099 A1 discloses a first and a second delay locked loop (DLL) circuit in a series arrangement. A switch is provided such that either the series arrangement or only the second PLL is used.

It is desirable to have a circuit that provides locking to an input signal, producing an output clock signal with low jitter while at the same time exhibiting a large locking range.

The invention suggests combining two PLL circuits having individual control stages, wherein one of the PLL circuits uses a TCXO and the other one uses a VCXO as an oscillator. The two PLL circuits are either operated individually or in a cascaded manner, depending on the operating mode.

In a first operating mode the two PLL circuits are connected in a first configuration that provides a larger locking range. To this end the input signal is supplied to both, the first and the second PLL circuit. The first PLL circuit has a controllable oscillator that has a relatively small pulling range and attempts to lock onto the input signal in the known way. Controllable oscillators having a relatively small pulling range but good phase frequency and temperature stability are, for example, temperature controlled crystal oscillators, or TCXOs. The controllable oscillator of the first PLL circuit has, however, the capability of oscillating with a nominal frequency in case of the absence of an input signal. In this case the first oscillator acts as a clock master which provides an excellent jitter quality. Further, the controllable oscillator of the first PLL circuit has a very stable phase and frequency behaviour. The second PLL circuit has a controllable oscillator which has a relatively large pulling range compared to the controllable oscillator of the first PLL circuit. The controllable oscillator of the second PLL circuit is, for example, a voltage controlled crystal oscillator, or VCXO. In the following specification the terms VCXO and TCXO are used as synonyms for controllable oscillators having a large or a small pulling range, respectively. The second PLL circuit thus has a large a locking range. In this first operating mode it also attempts to lock onto the input signal. As the second PLL circuit has a larger locking range it is very likely that it will lock onto the input signal at first. A lock detector provides information about the locking state of the first PLL circuit which has a smaller locking range than the second PLL. When the first PLL circuit is locked on to the input signal the two PLL circuits are connected in a second configuration that provides improved jitter behaviour compared to the first configuration, while having a smaller locking range. This operating mode is also referred to in the following as a second operating mode. Whenever the lock detector determines that the first PLL circuit is not locked the two PLL circuits are again connected in the first configuration. In case no input signal is present at all the TCXO oscillator of the first PLL circuit is oscillating freely at its nominal frequency. The output signal of the first PLL circuit is then supplied to the second PLL circuit, which locks onto the output signal of the first PLL circuit. This operating mode is also referred to in the following as a third operating mode.

The invention will be described in the following with reference to the drawing. In the drawing,
Figure 1 shows a block diagram of the inventive circuit;
Figure 2 shows a block diagram of the inventive circuit in a first operating mode;
Figure 3 shows a block diagram of the inventive circuit in a second operating mode; and
Figure 4 shows a block diagram of the inventive circuit in a third operating mode.

In the figures, same or similar elements are referenced with the same reference symbol.

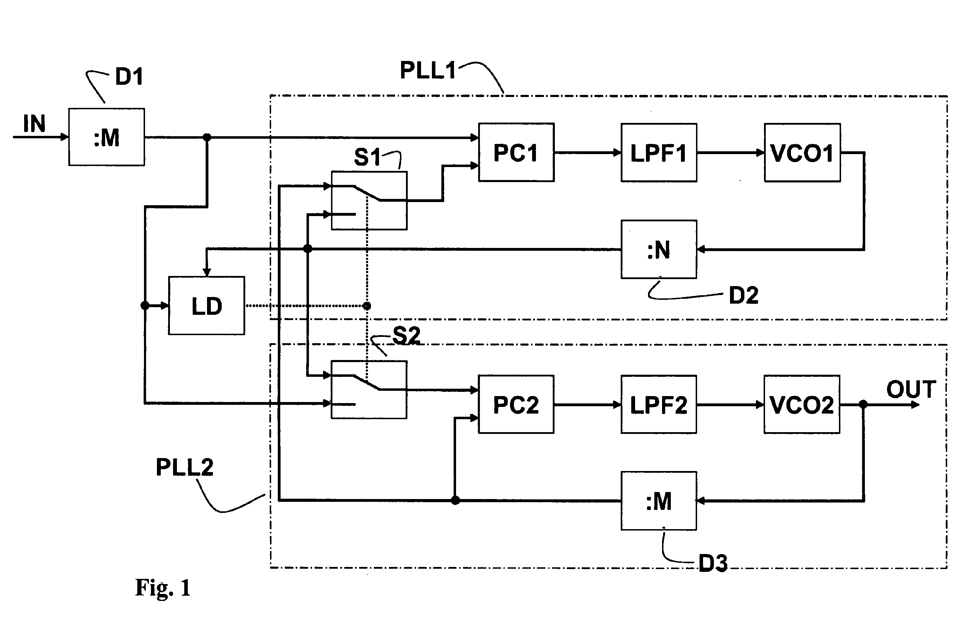

In figure 1 a block diagram of the inventive circuit is shown. An input signal IN is supplied via a first divider D1 to a first input of a first phase comparator PC1 of a first PLL circuit PLL1. To a second input of the first phase comparator PC1 an output signal of a first controllable oscillator VCO1 is supplied via a second divider D2 and a first switch S1. The first controllable oscillator VCO1 is controlled by the output signal of the first phase comparator PC1 which is supplied to the first controllable oscillator VCO1 via a first filter LPF1. The output signal of the first controllable oscillator VCO1 is further supplied to a lock detector LD, which also receives the input signal IN after division in the first divider D1. The lock detector LD controls the first switch S1, which selectively applies the output signal of the first controllable oscillator VCO1 or the output signal of a second controllable oscillator VCO2 to the second input of the first phase comparator PC1. The second controllable oscillator VCO2 is part of the second PLL circuit PLL2 and provides the output signal of the inventive circuit. The second PLL circuit PLL2 further includes a second phase comparator PC2 and a second filter LPF2. Like described for the first PLL circuit PLL1 the output signal of the phase comparator PC2 is applied to the second controllable oscillator VCO2 and via the second filter LPF2 for controlling the frequency of the output signal. The output signal is fed back to a first input of the second phase comparator PC2 via a third divider D3. A second switch S2 selectively applies the input signal IN downstream of the first divider D1 or the output signal of the first PLL circuit PLL1 to a second input of the second phase comparator PC2.

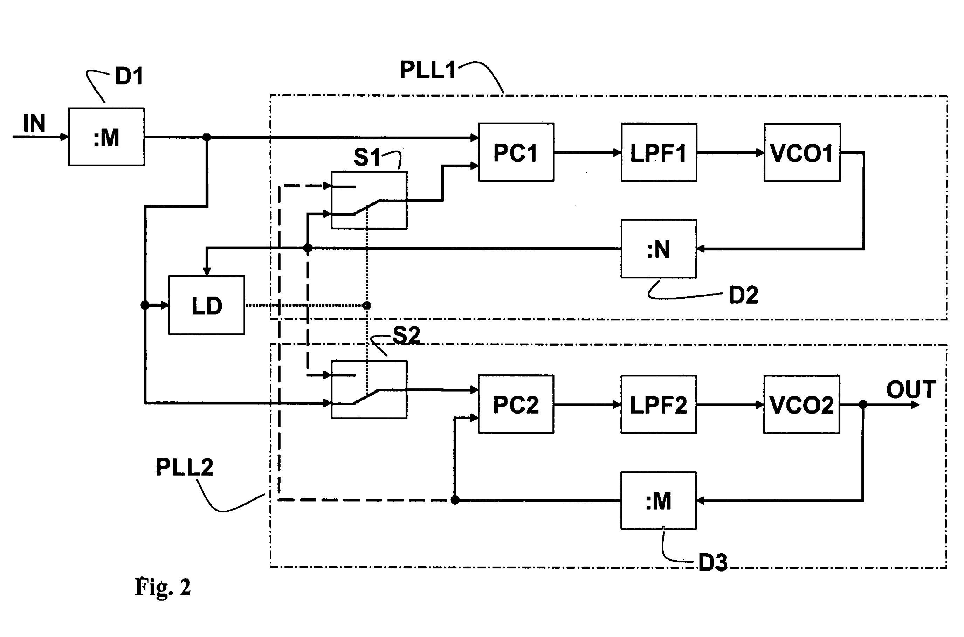

Figure 2 shows a schematic block diagram of the inventive circuit in a first operating mode. Solid lines indicate used connections carrying signals, while dashed lines indicate connections that are not used in this operating mode. An input signal IN is fed to a first input of a first phase comparator PC1 via a first divider D1. The output signal of the first phase comparator PC1 is filtered in a first filter LPF1 and controls a first controllable oscillator VCO1. The first controllable oscillator preferably is a TCXO. The output signal of the first controllable oscillator VCO1 is applied to a first selector switch S1 via a second divider D2. The first selector switch S1 is set to supply this signal to a second input of the first phase comparator PC1. The output signal of the first controllable oscillator VCO1 is also supplied to a lock detector LD which controls the first selector switch S1. The frequency-divided input signal IN is also supplied to the lock detector LD as well as to an input of a selector switch S2 which is set to apply this signal to a first input of a second phase comparator PC2. The selector switch S2 is likewise controlled by the lock detector LD. In this operating mode the two PLL circuits PLL1 and PLL2 that are formed by the respective components both try to lock onto the input signal IN. As the locking range of the second PLL circuit PLL2 is larger than that after first PLL circuit PLL1 the output signal of the inventive circuit will be locked rather quickly onto the input signal IN, however with a certain amount of jitter due to the properties of the second controllable oscillator VCO2. Despite the amount of jitter the output signal OUT of the inventive circuit is locked to the input signal IN. In case the frequency of the input signal IN lies in the locking range of the first PLL circuit PLL1 locking will occur. The lock detector detects the locking status of the first PLL circuit PLL1 and, upon detecting locking of the first PLL circuit PLL1 set the selector switches S1 and S2 accordingly to enter the second operating mode.

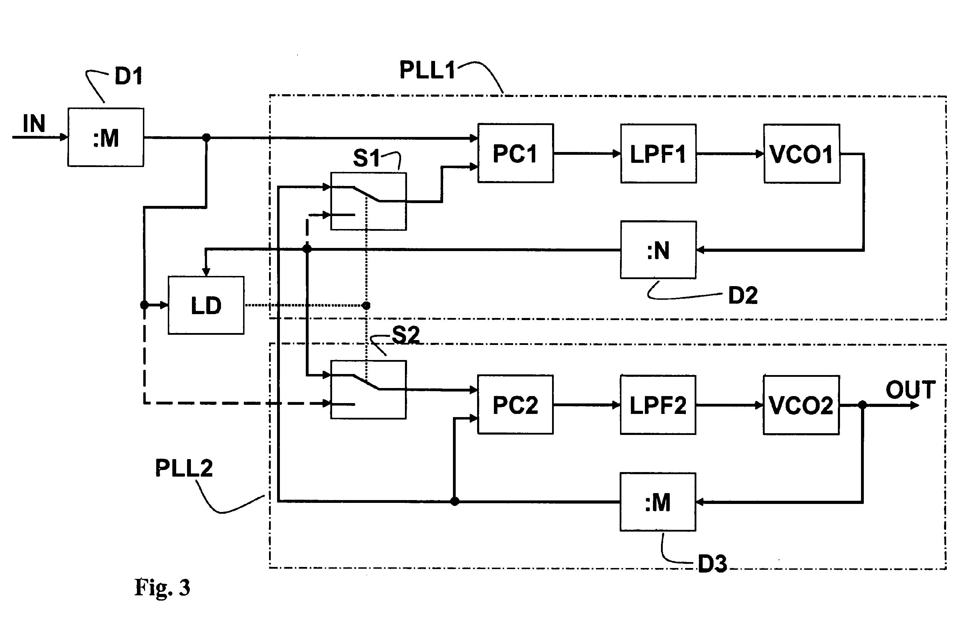

In figure 3 a schematic block diagram of the inventive circuit in the second operating mode is shown. After detecting locking of the first PLL circuit PLL1 to the input signal IN the lock detector LD set the selector switches S1 and S2 to feed the output signal of the first PLL circuit PLL1 to the second phase comparator PC2 and the output signal of the second PLL circuit PLL2 to the first phase comparator PC1, respectively. The first PLL circuit PLL1 locked onto the input signal IN provides a very stable output signal having low jitter. The second PLL circuit PLL2 locks onto the stable output signal of the first PLL circuit PLL1.

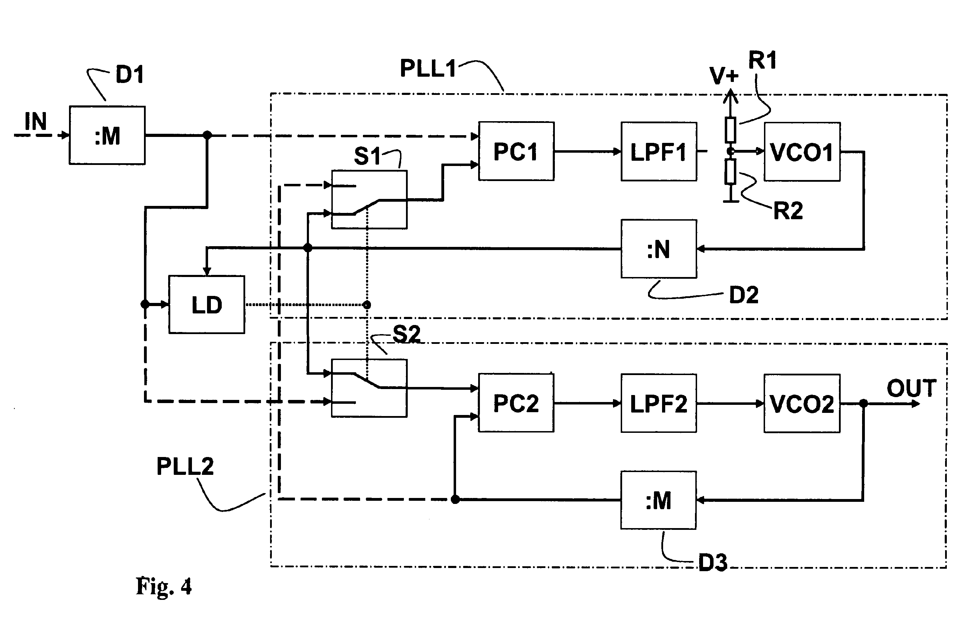

In figure 4 a schematic block diagram of the inventive circuit in a third operating mode in accordance with common knowledge of a person of ordinary skill in the art is shown. In this operating mode no input signal IN is present, and the first controllable oscillator VCO1 oscillates freely at its nominal frequency. The selector switch S2 is set to supply the output signal of the first controllable oscillator VCO1 to the second PLL circuit PLL2, which locks onto that signal, thereby providing a stable output frequency depending on the frequency of the first controllable oscillator VCO1. The output signal of the first controllable oscillator VCO1 is also supplied to the lock detector LD which also receives the input signal IN, if present. If the lock detector LD detects an input signal IN the selector switches S1 and S2 are set to enter the first operating mode in accordance with the invention. It is to be noted that the switch positions of the selector switches S1 and S2 may also be chosen to be similar to those of the second operating mode. In the third operating mode the first controllable oscillator VCO1 is disconnected from the first filter LPF1 and will oscillate at its nominal frequency. In one development the control input of the first controllable oscillator VCO1 is set to a predetermined level, e.g., by a resistor divider network R1, R2 between a supply voltage V+ and ground.

The divider ratios of the first and the second divider D1, D2, D3 are chosen according to the frequencies of the input signal IN and the oscillator frequencies of the first and the second controllable oscillator VCO1, VCO2.

It is to be noted that the first and the second divider D1, D2, D3 need not necessarily be present in the PLL circuit at all, depending on the input frequency range of the phase comparator. Further, depending on the way the phase comparator is built, the filter LPF1 need not necessarily be present at all in the PLL circuit.

In the specifications above the terms VCXO and TCXO have been exemplarily used in order to distinguish between controllable oscillators having different properties. It is to be noted that any of the letter having the respective properties can be used instead of those used in the specification.

The lock detector LD determines locking of the first PLL circuit PLL1 by evaluating the temporal distance of corresponding edges of the divided input signal IN and the output signal of the first PLL circuit PLL1 supplied to it. Corresponding edges are the rising or the falling edges of the two signals, respectively. As long as the temporal distance between the edges of the two signals changes PLL1 has not locked onto the input signal IN. Only if the temporal distance does not change, or if the change rate is below a predetermined value over a predetermined period of time, e.g. due to temperature drift, the PLL1 has locked onto the input signal IN and the lock detector changes over to the second operating mode.

One embodiment of the lock detector provides a counter that is started upon a first slope, either rising or falling, of a first signal out of the two signals applied to the lock detector LD. The counter is stopped in response to the corresponding slope of a second signal out of the two signals applied to the lock detector LD. The count value is stored and compared to subsequent count values. As long as the respective count values do not change, or change only at a predetermined, relatively small rate of change over a predetermined period of time, the status of the first PLL circuit PLL1 is considered to be locked.

When switching over between two of the different operating modes described above, the lock detector is, in one embodiment, inhibited for a predetermined period of time. This may be required due to transient behaviour of the oscillators and PLL circuits and the transients of the respective input signals.

## Claims

1. Electronic circuit with a first PLL circuit (PLL1) including a first phase comparator (PC1) and a first controllable oscillator (VCO1), with a second PLL circuit (PLL2) including a second phase comparator (PC2) and a second controllable oscillator (VCO2), wherein an input signal (IN) is connected to an input of the first phase comparator (PC1) of the first PLL circuit (PLL1), wherein a switch (S2) is provided for selectively connecting the input signal (IN) or the output signal of the first PLL circuit (PLL1) to an input of the second phase comparator (PC2) of the second PLL circuit (PLL2) wherein the output of the second PLL circuit (PLL2) is connected to a further input of the second phase comparator (PC2), **characterised in that** a further switch (S1) is provided for selectively connecting either the output signal of the first PLL circuit (PLL1) or the output signal of the second PLL circuit (PLL2) to a further input of the phase comparator of the first PLL circuit (PLL1) as a source of a feedback signal, and that the output of the second PLL circuit (PLL2) is the single output of the electronic circuit.

2. Electronic circuit according to claim 1 **characterised in that** a lock detection circuit (LD) is provided which is adapted to detect locking of the respective input signal (IN) to the output signal of the first controllable oscillator (VCO1) and, in case the input signal (IN) is locked to the output signal of the first controllable oscillator (VCO1), is adapted to control the first and the second switch (S1, S2) such that the output signal of the first PLL circuit (PLL1) is connected to an input of the phase comparator of the second PLL circuit (PLL2) and the output signal of the second PLL circuit (PLL2) is connected to an input of the phase comparator of the first PLL circuit (PLL1).

3. Electronic circuit according to claim 1 or 2 **characterised in that** the first PLL circuit (PLL1) further includes a first filter (LPF1) and/or the second PLL circuit (PLL2) further includes a second filter (LPF2).

4. Electronic circuit according to any one of the preceding claims **characterised in that** the first controllable oscillator (VCO1) has a pulling range that is smaller than that of the second controllable oscillator (VCO2).

5. Electronic circuit according to any one of the preceding claims **characterised in that** frequency dividers (D1, D2, D3) are provided between the input terminal (IN) and the first phase comparator (PC1), the output of the first controllable oscillator (VCO1) and respective inputs of the first and the second switch (S1, S2) and/or the output of the second controllable oscillator (VCO2) and the respective inputs of the second phase comparator (PC2) and the first switch (S1).

6. Method for operating an electronic circuit according to one of claims 1 to 5 including the steps of:
- directly supplying an input signal (IN) to an input of a phase comparator of a first PLL circuit (PLL1);
- supplying, via a switch (S2) the input signal to an input of a phase comparator of a second PLL circuit (PLL2);
- feeding back the signal of a second controllable oscillator ( VCO2) of the second PLL circuit (PLL2) to a further input of the second phase comparator (PC2) of the second PLL circuit (PLL2); and feeding back the signal of a first controllable oscillator (VCO1) of the first PLL (PLL1) to a further input of the first phase comparator (PC1) via a further switch (S1); and
- monitoring the lock status of the first PLL circuit (PLL1) with regard to the input signal (IN) in a lock detector (LD);
**characterised in that** the method further comprises the steps of:
- controlling the second switch (S2) to exclusively supply the output signal of the first PLL circuit (PLL1) to the input of the phase comparator of the second PLL circuit (PLL2), and controlling the first switch (S1) to exclusively supply the output signal of the second PLL circuit (PLL2) to the further input of the first PLL circuit (PLL1), when the first PLL circuit (PLL1) is locked onto the input signal (IN).

## Patentansprüche

1. Elektronischer Schaltkreis mit einem ersten PLL-Schaltkreis (PLL1), der einen ersten Phasenkomparator (PC1) und einen ersten steuerbaren Oszillator (VCO1) enthält, mit einem zweiten PLL-Schaltkreis (PLL2), der einen zweiten Phasenkomparator (PC2) und einen zweiten steuerbaren Oszillator (VCO2) enthält, wobei ein Eingangssignal (IN) mit einem Eingang des ersten Phasenkomparators (PC1) des ersten PLL-Schaltkreises (PLL1) verbunden ist, wobei ein Schalter (S2) zum wahlweisen Verbinden des Eingangssignals (IN) oder des Ausgangssignals des ersten PLL-Schaltkreises (PLL1) mit einem Eingang des zweiten Phasenkomparators (PC2) des zweiten PLL-Schaltkreises (PLL2) vorgesehen ist, wobei der Ausgang des zweiten PLL-Schaltkreises (PLL2) mit einem weiteren Eingang des zweiten Phasenkomparators (PC2) verbunden ist, **dadurch gekennzeichnet, dass** ein weiterer Schalter (S1) zum wahlweisen Verbinden entweder des Ausgangssignals des ersten PLL-Schaltkreises (PLL1) oder des Ausgangssignals des zweiten PLL-Schaltkreises (PLL2) mit einem weiteren Eingang des Phasenkomparators des ersten PLL-Schaltkreises (PLL1) als eine Quelle eines Rückkopplungssignals vorgesehen ist, und **dadurch**, dass der Ausgang des zweiten PLL-Schaltkreises (PLL2) der einzige Ausgang des elektronischen Schaltkreises ist.

2. Elektronischer Schaltkreis gemäß Anspruch 1, **dadurch gekennzeichnet, dass** ein Verriegelungserfassungsschaltkreis (LD) vorgesehen ist, der die Verriegelung des jeweiligen Eingangssignals (IN) mit dem Ausgangssignal des ersten steuerbaren Oszillators (VCO1) erfassen kann, und, falls das Eingangssignal (IN) mit dem Ausgangssignal des ersten steuerbaren Oszillators (VCO1) verriegelt ist, den ersten und den zweiten Schalter (S1, S2) so steuern kann, dass das Ausgangssignal des ersten PLL-Schaltkreises (PLL1) mit einem Eingang des Phasenkomparators des zweiten PLL-Schaltkreises (PLL2) verbunden wird und dass das Ausgangssignal des zweiten PLL-Schaltkreises (PLL2) mit einem Eingang des Phasenkomparators des ersten PLL-Schaltkreises (PLL1) verbunden wird.

3. Elektronischer Schaltkreis gemäß Anspruch 1 oder 2, **dadurch gekennzeichnet, dass** der erste PLL-Schaltkreis (PLL1) ferner ein erstes Filter (LPF1) enthält und/oder dass der zweite PLL-Schaltkreis (PLL2) ferner ein zweites Filter (LPF2) enthält.

4. Elektronischer Schaltkreis gemäß einem der vorstehenden Ansprüche, **dadurch gekennzeichnet, dass** der erste steuerbare Oszillator (VCO1) einen Ziehbereich aufweist, der kleiner als der des zweiten steuerbaren Oszillators (VCO2) ist.

5. Elektronischer Schaltkreis gemäß einem der vorstehenden Ansprüche, **dadurch gekennzeichnet, dass** zwischen dem Eingangsanschluss (IN) und dem ersten Phasenkomparator (PC1), zwischen dem Ausgang des ersten steuerbaren Oszillators (VCO1) und den jeweiligen Eingängen des ersten und des zweiten Schalters (S1, S2) und/oder zwischen dem Ausgang des zweiten steuerbaren Oszillators (VCO2) und den jeweiligen Eingängen des zweiten Phasenkomparators (PC2) und des ersten Schalters (S1) Frequenzteiler (D1, D2, D3) vorgesehen sind.

6. Verfahren zum Betreiben eines elektronischen Schaltkreises gemäß einem der Ansprüche 1 bis 5, wobei das Verfahren die folgenden Schritte enthält:
- direktes Zuführen eines Eingangssignals (IN) zu einem Eingang eines Phasenkomparators eines ersten PLL-Schaltkreises (PLL1):
- Zuführen des Eingangssignals zu einem Eingang eines Phasenkomparators eines zweiten PLL-Schaltkreises (PLL2) über einen Schalter (S2);
- Rückkoppeln des Signals eines zweiten steuerbaren Oszillators (VCO2) des zweiten PLL-Schaltkreises (PLL2) zu einem weiteren Eingang des zweiten Phasenkomparators (PC2) des zweiten PLL-Schaltkreises (PLL2); und Rückkoppeln des Signals eines ersten steuerbaren Oszillators (VCO1) des ersten PLL (PLL1) zu einem weiteren Eingang des ersten Phasenkomparators (PC1) über einen weiteren Schalter (S1); und
- Überwachen des Verriegelungsstatus des ersten PLL-Schaltkreises (PLL1) in Bezug auf das Eingangssignal (IN) in einem Verriegelungsdetektor (LD);
**dadurch gekennzeichnet, dass** das Verfahren ferner die folgenden Schritte umfasst:
- Steuern des zweiten Schalters (S2) zum ausschließlichen Zuführen des Ausgangssignals des ersten PLL-Schaltkreises (PLL1) zu dem Eingang des Phasenkomparators des zweiten PLL-Schaltkreises (PLL2) und Steuern des ersten Schalters (S1) zum ausschließlichen Zuführen des Ausgangssignals des zweiten PLL-Schaltkreises (PLL2) zu dem weiteren Eingang des ersten PLL-Schaltkreises (PLL1), wenn der erste PLL-Schaltkreis (PLL1) an dem Eingangssignal (IN) verriegelt ist.

## Revendications

1. Circuit électronique avec un premier circuit PLL (PLL1) incluant un premier comparateur de phase (PC1) et un premier oscillateur commandable (VCO1), avec un deuxième circuit PLL (PLL2) incluant un deuxième comparateur de phase (PC2) et un deuxième oscillateur commandable (VCO2), où un signal d'entrée (IN) est connecté à une entrée du premier comparateur de phase (PC1) du premier circuit PLL (PLL1), où un commutateur (S2) est fourni pour connecter de façon sélective le signal d'entrée (IN) ou le signal de sortie du premier circuit PLL (PLL1) à une entrée du deuxième comparateur de phase (PC2) du deuxième circuit PLL PLL2), où la sortie du deuxième circuit PLL (PLL2) est connectée à une entrée supplémentaire du deuxième comparateur de phase (PC2), **caractérisé en ce qu'**un commutateur supplémentaire (S1) est fourni pour connecter de façon sélective le signal de sortie du premier circuit PLL (PLL1) ou le signal de sortie du deuxième circuit PLL (PLL2) à une entrée supplémentaire du comparateur de phase du premier circuit PLL (PLL1) en tant que source d'un signal de réaction, et que la sortie du deuxième circuit PLL (PLL2) constitue la sortie unique du circuit électronique.

2. Circuit électronique selon la revendication 1, **caractérisé en ce qu'**un circuit de détection de verrouillage (LD) est fourni, lequel est adapté pour détecter le verrouillage du signal d'entrée (IN) respectif au signal de sortie du premier oscillateur commandable (VC01) et, dans le cas où le signal d'entrée (IN) est verrouillé au signal de sortie du premier oscillateur commandable (VCO1), est adapté pour commander le premier et le deuxième commutateur (S1, S2) de sorte que le signal de sortie du premier circuit PLL (PLL1) soit connecté à une entrée du comparateur de phase du deuxième circuit PLL (PLL2) et que le signal de sortie du deuxième circuit PLL (PLL2) soit connecté à une entrée du comparateur de phase du premier circuit PLL (PLL1).

3. Circuit électronique selon la revendication 1 ou 2, **caractérisé en ce que** le premier circuit PLL (PLL1) inclut en outre un premier filtre (LPF1) et/ou que le deuxième circuit PLL (PLL2) inclut en outre un deuxième filtre (LPF2).

4. Circuit électronique selon une quelconque des revendications précédentes, **caractérisé en ce que** le premier oscillateur commandable (VC01) possède une plage de décalage inférieure à celle du deuxième oscillateur commandable (VCO2).

5. Circuit électronique selon une quelconque des revendications précédentes, **caractérisé en ce que** des diviseurs de fréquence (D1, D2, D3) sont fournis entre la borne d'entrée (IN) et le premier comparateur de phase (PC1), la sortie du premier oscillateur commandable (VC01) et les entrées respectives du premier et du deuxième commutateur (S1, S2) et/ou la sortie du deuxième oscillateur commandable (VCO2) et les entrées respectives du deuxième comparateur de phase (PC2) et du premier commutateur (S1).

6. Procédé pour le fonctionnement d'un circuit électronique selon une des revendications 1 à 5, incluant les étapes consistant à :
- fournir directement un signal d'entrée (IN) à une entrée d'un comparateur de phase d'un premier circuit PLL (PLL1) ;
- fournir, via un commutateur (S2), le signal d'entrée à une entrée d'un comparateur de phase d'un deuxième circuit PLL (PLL2) ;
- renvoyer le signal d'un deuxième oscillateur commandable (VCO2) du deuxième circuit PLL (PLL2) à une entrée supplémentaire du deuxième comparateur de phase (PC2) du deuxième circuit PLL (PLL2) et renvoyer le signal d'un premier oscillateur commandable (VCO1) du premier circuit PLL (PLL1) à une entrée supplémentaire du premier comparateur de phase (PC1) via un commutateur supplémentaire (S1) et
- contrôler le statut de verrouillage du premier circuit PLL (PLL1) par rapport au signal d'entrée (IN) dans un détecteur de verrouillage (LD) ;
**caractérisé en ce que** le procédé comprend en outre les étapes consistant à :
- commander le deuxième commutateur (S2) pour fournir exclusivement le signal de sortie du premier circuit PLL (PLL1) à l'entrée du comparateur de phase du deuxième circuit PLL (PLL2) et commander le premier commutateur (S1) pour fournir exclusivement le signal de sortie du deuxième circuit PLL (PLL2) à l'entrée supplémentaire du premier circuit PLL (PLL1), lorsque le premier circuit PLL (PLL1) est verrouillé sur le signal d'entrée (IN).
